Europäisches Patentamt

European Patent Office

Office européen des brevets

(11) Publication number: **0 073 136**
**B1**

# EUROPEAN PATENT SPECIFICATION

(45) Date of publication of patent specification: **12.11.86**

(51) Int. Cl.⁴: **H 01 L 21/308, G 03 F 7/26**

(21) Application number: **82304358.3**

(22) Date of filing: **18.08.82**

(54) Photomask material.

(30) Priority: **19.08.81 JP 130460/81**

(43) Date of publication of application:
**02.03.83 Bulletin 83/09**

(45) Publication of the grant of the patent:
**12.11.86 Bulletin 86/46**

(84) Designated Contracting States:
**DE FR GB**

(56) References cited:
EP-A-0 054 736
DE-B-2 024 822
US-A-3 975 003

SOLID STATE TECHNOLOGY, July 1972, D.L.
SPEARS AND HENRY I. SMITH "X-Ray
Lithography - A new high resolution replication
process", pages 21-26

(73) Proprietor: KONISHIROKU PHOTO INDUSTRY
CO. LTD.
No. 26-2, Nishishinjuku 1-chome Shinjuku-ku
Tokyo 160 (JP)

(72) Inventor: Hatano, Takashi
467 Kamionkata-chi
Hachioji-shi Tokyo (JP)
Inventor: Maruyama, Akira
1698-7 Onakage Hidakamachi
Iruma-gun Saitama-ken (JP)

(74) Representative: Ellis-Jones, Patrick George
Armine et al
J.A. KEMP & CO. 14 South Square Gray's Inn
London WC1R 5EU (GB)

**Description**

This invention relates to an improvement in the photomask material used in the production process for semiconductor devices or the like.

One of the most important processes in the production of semiconductor devices or the like is the formation of a fine pattern by photoetching. Photomasks are essential to the process. Photomasks include two types, namely emulsion masks and hard masks. However, as a higher pattern density is now needed, hard masks exhibiting excellent pattern sharpness, excellent line width reproducibility and few defects are widely used in the production of semiconductor devices in which a higher density is needed.

Generally, the hard masks comprise thin films of chromium, chromium oxide, iron oxide and silicon provided on transparent substrates made of glass or the like. In the formation of a fine pattern by photoetching, the pattern sharpness and line width reproducibility are adversely affected by the fact that the incident light for exposure is reflected by the surface of a silicon wafer and the reflected light is again reflected from the surface of the opaque section of the mask so that it again enters into the silicon wafer. To prevent this phenomenon, the socalled low-reflection type chromium masks comprising a chromium oxide film superposed on metallic chromium are widely used. EP—A—54736, which falls within the terms of Art. 54(3) of the EPC, discloses a photomask wherein a low reflection layer contains an oxide and nitride of chromium or tantalum.

On the other hand, unlike the emulsion masks, the hard masks are advantageous in that they can be reused by washing them even when they are stained through use. Particularly, strong acid such as hot concentrated sulfuric acid are generally used to remove a photoresist attached when a pattern is transferred to a silicon wafer by contact printing. Therefore, the photomasks must withstand the strong acid.

However, the conventional masks formed by stacking metallic chromium and chromium oxide layers exhibit a low resistance to strong acids, and their repeated use is limited. Further, the conventional masks do not exhibit sufficient etching characteristics needed by photomasks for use in the preparation of fine patterns. This is because metallic chromium and chromium oxide have different etching speeds with respect to an etching solution. In addition, with the conventional masks, the resist adhesion is insufficient, and a sufficient dimensional accuracy cannot be obtained when forming a fine pattern.

The primary object of the present invention is to provide a photomask material capable of resisting a strong acid cleaning solution and which can be used for repeated use of the photomask material.

The present invention provides a photomask material comprising a substrate at least one layer comprising a metal and at least one of oxygen and nitrogen and at least one layer comprising said metal and nitrogen and, optionally, oxygen, the two said layers being different, such that in a layer comprising metal and oxygen the ratio of metal to oxygen is between 99:1 and 30:70 and in a layer comprising metal and nitrogen the ratio of metal to nitrogen is between 99:1 and 30:70.

The photomask material of the present invention may comprise a substrate and a mask layer provided on said substrate comprising a first layer containing a "lower" metal to oxygen and metal to nitrogen ratio, and a second layer containing a "higher" metal to oxygen and metal to nitrogen ratio. Preferably the second layer lies over the first layer. By a "higher" metal to oxygen ratio is meant a ratio between 50:50 and 30:70 (both inclusive) respectively, and by a "lower" metal to oxygen ratio is meant a ratio between 99:1 (inclusive) and 50:50 (exclusive). By a "higher" metal to nitrogen ratio is meant a ratio of metal to nitrogen between 75:25 and 30:70 (both inclusive), and a "lower" metal to nitrogen ratio means a ratio between 99:1 (inclusive) and 72:25 (exclusive).

The photomask material in accordance with the present invention exhibits excellent resistance to etching and allows uniform etching.

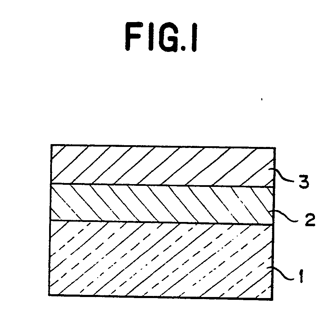

A photomask material in accordance with the present invention is illustrated, merely by way of example, with reference to Figure 1 which is a sectional view of a typical chromium mask of this invention. This can be obtained by forming a layer 2 with a "lower" metal to oxygen and/or a "lower" metal to nitrogen ratio on substrate 1, and stacking a layer 3 with a "higher" metal to oxygen and a "higher" metal to nitrogen, or a "higher" metal to nitrogen ratio, the metal being the same in both layers.

The aforesaid substrate should be not only transparent visually but also permeable to electromagnetic waves used for exposure, for example X-rays. A transparent intermediate layer may be formed on the substrate. In the present invention, metals which can be converted into oxides and nitrides soluble in an etching solution, such as chromium, titanium, molybdenum, tantalum and tungsten, may be used. Chromium is particularly preferred. The metal oxides and nitrides can be formed on the substrate by known procedure, for example by sputtering a metal in an atmosphere of argon, oxygen or nitrogen gas. For convenience the terms "metal oxide" and "metal nitride" will be used to denote layers comprising metal and oxygen, and metal and nitrogen, respectively.

When a layer containing a mixture of an oxide and a nitride is formed on the substrate, a layer containing a mixture of a higher oxide and a higher nitride may be formed adjacent to the substrate, and then a layer of a lower oxide or a lower nitride may be formed on the mixed layer thus formed. Alternatively, after the aforesaid mixed layer is formed, a layer containing a mixture of a higher oxide and a higher nitride may be formed on the mixed layer. Alternatively, a layer containing a lower oxide and/or a lower nitride may be formed as the lowermost layer, and a layer containing a mixture of a higher oxide and

# 0 073 136

a higher nitride may be stacked on the lowermost layer. Further, the same technical effect can be obtained also when the aforesaid layer containing a mixture of an oxide and a nitride is formed via a transparent intermediate layer on the substrate.

The photomask material in accordance with the present invention comprises a mixed layer in which the degrees of oxidation and nitriding of the same metal may differ stacked on the substrate. Therefore, the photomask material in accordance with the present invention exhibits excellent resistance to the cleaning solutions used and can be used repeatedly. Further, the photomask material can be used without changing the etching treatment and etching conditions. In addition, the photomask material exhibits excellent etching characteristics and can be adapted to fine patterns.

The present invention is hereinafter illustrated in further detail by the following nonlimitative Examples.

### Example 1

A layer containing chromium oxide in which the element ratio of chromium to oxygen was 90:10 was formed to a thickness of 80 nm (800 Å) on a glass substrate. Then, a layer containing a mixture of chromium oxide in which the element ratio of chromium to oxygen was 40:60 and chromium nitride in which the element ratio of chromium to nitrogen was 50:50 was formed to a thickness of 30 nm (300 Å) on the previously formed layer.

When the two-layer film thus formed was etched with a ceric nitrate-based etching solution, the etching completion time was 40 sec. The degree of protrusion-recession of the pattern edge was ±0.03 μm or less, and the degree of side etching by 10 sec over-etching was 0.1 μm. Further, when the mask after patterning was dipped in concentrated sulfuric acid at 120°C for one hour, no change was observed in the transmission and pattern shape. The adhesion to a resist was satisfactory, and the fluctuation in the pattern line width was very small. ($\delta \leqq 0.1$ μm).

From Table 1 shown below, it is clear that the above-mentioned results are obtained also when the same mixed layer as the uppermost layer is provided as the first layer.

TABLE 1

| | Present invention | | Conventional technique | |
| --- | --- | --- | --- | --- |
| | Lower layer | Upper layer | Chromium oxide | Completely oxidized chromium |
| Dissolving speed with hot conc. sulfuric acid | 2.7 nm/hr (27 Å/hr) or less | 2 or less | 3000 | 120 |
| Etching speed | 2.9 | 2.8 | 3.0 | 1.5 |

As shown above, when a layer containing a lower chromium oxide is combined with a layer containing a mixture of a higher chromium oxide and a higher chromium nitride, a low-reflection chromium mask exhibiting excellent resistance to acids and excellent etching characteristics and capable of being treated by the same methods and under the same conditions as the conventional technique is obtained.

### Example 2

A layer containing chromium nitride in which the element ratio of chromium to nitrogen was 85:15 was formed to a thickness of 80 nm (800 Å) on a glass substrate. Then, a layer containing a mixture of chromium oxide in which the element ratio of chromium to oxygen was 40:60 and chromium nitride in which the element ratio of chromium to nitrogen was 50:50 was formed to a thickness of 30 nm (300 Å) on the previously formed layer.

When the two-layer film thus formed was etched with a ceric nitrate-based etching solution, the etching completion time was 48 sec. The degree of protrusion-recession of the pattern edge was ±0.03 μm or less, and the degree of side etching by 10 sec over-etching was 0.1 μm. Further, when the mask after patterning was dipped in concentrated sulfuric acid at 120°C for one hour, no change was observed in the transmission and pattern shape. The adhesion to a resist was satisfactory, and the fluctuation in the pattern line width was very small. ($\delta \leqq 0.1$ μm).

From the table 2 shown below, it is clear that the above-mentioned results are obtained also when the same mixed layer as the uppermost layer is provided as the first layer.

3

TABLE 2

|  | Present invention | | Conventional technique | |
|---|---|---|---|---|
|  | Lower layer | Upper layer | Chromium oxide | Completely oxidized chromium |
| Dissolving speed with hot conc. sulfuric acid | 2.7 nm/hr (27 Å/hr) or less | 2.0 or less | 3000 | 120 |
| Etching speed | 3.0 | 2.8 | 3.0 | 1.5 |

As shown above, when a layer containing a lower chromium nitride is combined with a layer containing a mixture of a higher chromium oxide and a higher chromium nitride, a low-reflection chromium mask exhibiting excellent resistance to acids and excellent etching characteristics and capable of being treated by the same methods and under the same conditions as the conventional technique is obtained.

Example 3

A layer containing chromium oxide in which the element ratio of chromium to oxygen was 90:10 was formed to a thickness of 80 nm (800 Å) on a glass substrate. Then, a layer containing chromium nitride in which the element ratio of chromium to nitrogen was 50:50 was formed to a thickness of 30 nm (300 Å) on the previously formed layer.

When the two-layer film thus formed was etched with a ceric nitrate-based etching solution, the etching completion time was 40 sec. The degree of protrusion-recession of the pattern edge was ±0.03 μm or less, and the degree of side etching by 10 sec over-etching was 0.1 μm. Further, when the mask after patterning was dipped in concentrated sulfuric acid at 120°C for one hour, no change was observed in the transmission and pattern shape. The adhesion to a resist was satisfactory, and the fluctuation in the pattern line width was very small. ($\delta \leqq 0.1$ μm).

From the Table 3 shown below, it is clear that the above-mentioned results are obtained also when the same mixed layer as the uppermost layer is provided as the first layer.

TABLE 3

|  | Present invention | | Conventional technique | |
|---|---|---|---|---|
|  | Lower layer | Upper layer | Chromium oxide | Completely oxidized chromium |
| Dissolving speed with hot conc. sulfuric acid | 2.7 nm/hr (27 Å/hr) or less | 2.0 or less | 3000 | 120 |
| Etching speed | 2.9 | 3.1 | 3.0 | 1.5 |

As shown above, when a layer containing a lower chromium oxide is combined with a layer containing a higher chromium nitride, a low-reflection chromium mask exhibiting excellent resistance to acids and excellent etching characteristics and capable of being treated by the same methods and under the same conditions as the conventional technique is obtained.

Example 4

A layer containing a mixture of chromium oxide in which the element ratio of chromium to oxygen was 85:15 and chromium nitride in which the element ratio of chromium to nitrogen was 90:10 was formed to a thickness of 80 nm (800 Å) on a glass substrate. Then, a layer containing chromium nitride in which the element ratio of chromium to nitrogen was 50:50 was formed to a thickness of 30 nm (300 Å) on the previously formed layer.

When the two-layer film thus formed was etched with a ceric nitrate-based etching solution, the etching completion time was 40 sec. The degree of protrusion-recession of the pattern edge was ±0.03 μm

**0 073 136**

or less, and the degree of side etching by 10 sec over-etching was 0.1 µm. Further, when the mask after patterning was dipped in concentrated sulfuric acid at 120°C for one hour, no change was observed in the transmission and pattern shape. The adhesion to a resist was satisfactory, and the fluctuation in the pattern line width was very small. ($\delta \leq 0.1$ µm).

From the Table 4 shown below, it is clear that the above-mentioned results are obtained also when the same mixed layer as the uppermost layer is provided as the first layer.

TABLE 4

| | Present invention | | Conventional technique | |
|---|---|---|---|---|
| | Lower layer | Upper layer | Chromium oxide | Completely oxidized chromium |
| Dissolving speed with hot conc. sulfuric acid | 2.7 nm/hr (27 Å/hr) or less | 2.0 or less | 3000 | 120 |
| Etching speed | 2.7 | 3.1 | 3.0 | 1.5 |

As shown above, when a layer containing a mixture of a lower chromium oxide and a lower chromium nitride is combined with a layer containing a higher chromium nitride, a low-reflection chromium mask exhibiting excellent resistance to acids and excellent etching characteristics and capable of being treated by the same methods and under the same conditions as the conventional technique is obtained.

Example 5

A layer containing chromium nitride in which the element ratio of chromium to nitrogen was 85:15 was formed to a thickness of 80 nm (800 Å) on a glass substrate. Then, a layer containing chromium nitride in which the element ratio of chromium to nitrogen was 50:50 was formed to a thickness of 30 nm (300 Å) on the previously formed layer.

When the two-layer film thus formed was etched with a ceric nitrate-based etching solution, the etching completion time was 44 sec. The degree of protrusion-recession of the pattern edge was ±0.03 µm or less, and the degree of side etching by 10 sec over-etching was 0.1 µm. Further, when the mask after patterning was dipped in concentrated sulfuric acid at 120°C for one hour, no change was observed in the transmission and pattern shape. The adhesion to a resist was satisfactory, and the fluctuation in the pattern line width was very small. ($\delta \leq 0.1$ µm).

From the Table 5 shown below, it is clear that the above-mentioned results are obtained also when the same mixed layer as the uppermost layer is provided as the first layer.

TABLE 5

| | Present invention | | Conventional technique | |
|---|---|---|---|---|
| | Lower layer | Upper layer | Chromium oxide | Completely oxidized chromium |
| Dissolving speed with hot conc. sulfuric acid | 27 Å/hr or less | 20 or less | 30,000 | 1,200 |
| Etching speed | 30 | 31 | 30 | 15 |

As described above, when a layer containing a lower chromium nitride is combined with a layer containing a higher chromium nitride, a low-reflection chromium mask exhibiting excellent resistance to acids and excellent etching characteristics and capable of being treated by the same methods and under the same conditions as the conventional technique is obtained.

The masks thus formed can be washed many times with a strong acid and damage of the mask due to cleaning is minimized. Therefore, the yield of the product is improved and the cost can be reduced. Thus the present invention is practically extremely useful.

5

# 0 073 136

**Claims**

1. A photomask material comprising a substrate, at least one layer comprising a metal and at least one of oxygen and nitrogen, and at least one layer comprising said metal and nitrogen and, optionally, oxygen, the two said layers being different, such that in a layer containing metal and oxygen the metal to oxygen ratio is between 99:1 and 30:70 and in a layer containing metal and nitrogen the metal to nitrogen ratio is between 99:1 and 30:70.

2. A photomask material according to Claim 1 wherein the metal is at least one of chromium, titanium, molybdenum, tantalum and tungsten.

3. A photomask material according to Claim 2, wherein the metal is chromium.

4. A photomask material according to any one of Claims 1 to 3 comprising a substrate, and, on said substrate, a first layer comprising a metal, oxygen and nitrogen, and a second layer comprising a metal, oxygen and nitrogen such that in said first layer the metal to oxygen ratio is between 99:1 (inclusive) and 50:50 (exclusive) and the metal to nitrogen ratio is between 99:1 (inclusive) and 75:25 (exclusive) and in said second layer the metal to oxygen ratio is between 50:50 and 30:70 (both inclusive), and the metal to nitrogen ratio is between 75:25 and 30:70 (both inclusive).

5. A photomask material according to Claim 4 wherein said second layer lies over said first layer.

**Patentansprüche**

1. Photomaskenmaterial aus einem Substrat, mindestens einer ein Metall sowie Sauerstoff und/oder Stickstoff enthaltenden Schicht und mindestens einer das Metall und Stickstoff sowie gegebenenfalls Sauerstoff enthaltenden Schicht, wobei sich die beiden Schichten darin unterscheiden, daß in einer Metall und Sauerstoff enthaltenden Schicht das Verhältnis Metall/Sauerstoff 99:1 bis 30:70 beträgt und in einer Metall und Stickstoff enthaltenden Schicht das Verhältnis Metall/Stickstoff 99:1 bis 30:70 beträgt.

2. Photomaskenmaterial nach Anspruch 1, dadurch gekennzeichnet, daß das Metall aus Chrom, Titan, Molybdän, Tantal und/oder Wolfram besteht.

3. Photomaskenmaterial nach Anspruch 2, dadurch gekennzeichnet, daß das Metall aus Chrom besteht.

4. Photomaskenmaterial nach einem der Ansprüche 1 bis 3 aus einem Substrat und—auf dem Substrat—einer ersten, ein Metall, Sauerstoff und Stickstoff enthaltenden Schicht und einer zweiten, ein Metall, Sauerstoff und Stickstoff enthaltenden Schicht, wobei in der ersten Schicht das Verhältnis Metall/Sauerstoff zwischen 99:1 (einschließlich) und 50:50 (ausschließlich) und das Verhältnis Metall/Stickstoff zwischen 99:1 (einschließlich) und 75:25 (ausschließlich) liegen und in der zweiten Schicht das Verhältnis Metall/Sauerstoff zwischen 50:50 und 30:70 (beide einschließlich) und das Verhältnis Metall/Stickstoff zwischen 75:25 und 30:70 (beide einschließlich) liegen.

5. Photomaskenmaterial nach Anspruch 4, dadurch gekennzeichnet, daß die zweite Schicht über der ersten Schicht angeordnet ist.

**Revendications**

1. Matériau de photomasque comprenant un substrat, au moins une couche comprenant un métal ainsi que de l'oxygène et/ou de l'azote, et au moins une couche comprenant ledit métal et de l'azotecuivrique si on le désire, de l'oxygène, les deux couches étant différentes, de telle sorte que dans une couche contenant un métal et de l'oxygène, le rapport du métal à l'oxygène est compris entre 99:1 et 30:70 et, dans une couche contenant un métal et de l'azote, le rapport du métal à l'azote est compris entre 99:1 et 30:70.

2. Matériau de photomasque selon la revendication 1, dans lequel le métal est au moins un des métaux du groupe comprenant le chrome, le titane, le molybdène, le tantale et le tungstène.

3. Matériau de photomasque selon la revendication 2, dans lequel le métal est le chrome.

4. Matériau de photomasque selon l'une quelconque des revendications 1 à 3, comprenant un substrat, et sur ledit substrat, une première couche comprenant un métal, de l'oxygène et de l'azote et une seconde couche comprenant un métal, de l'oxygène et de l'azote, de telle sorte que, dans ladite première couche, le rapport du métal à l'oxygène soit compris entre 99:1 (inclus) et 50:50 (exclu) et le rapport du métal à l'azote soit compris entre 99:1 (inclu) et 79:25 (exclu) et que, dans ladite seconde couche, le rapport du métal à l'oxygène soit compris entre 50:50 et 30:70 (tous deux inclus) et le rapport du métal à l'azote soit compris entre 75:25 et 30:70 (tous deux inclus).

5. Matériau de photomasque selon la revendication 4, dans lequel ladite seconde couche est placée sur ladite première couche.

# FIG.1